# EUROPEAN PATENT SPECIFICATION

(11) **EP 3 648 338 B1**
(45) Date of publication and mention of the grant of the patent: **16.02.2022**
(21) Application number: 17915537.9
(22) Date of filing: 29.06.2017
(51) Int. Cl.: H02P 29/024

(54) **DIAGNOSTIC DEVICE FOR ELECTRIC MOTOR**
DIAGNOSEVORRICHTUNG FÜR EINEN ELEKTROMOTOR
DISPOSITIF DE DIAGNOSTIC DE MOTEUR ÉLECTRIQUE

(43) Date of publication of application: 06.05.2020
(73) Proprietor: Mitsubishi Electric Corporation, Chiyoda-ku Tokyo 100-8310 (JP)
(72) Inventor: MIYAUCHI, Toshihiko, Tokyo 100-8310 (JP)
(74) Representative: Witte, Weller & Partner Patentanwälte mbB
(86) International application number: PCT/JP2017/023993
(87) International publication number: WO 2019/003389

(56) References cited:
- CN-A- 105 510 051
- JP-A- 2015 179 030
- JP-A- 2015 227 889
- JP-A- 2016 195 524
- JP-A- 2016 195 524

## Description

### TECHNICAL FIELD

The present invention relates to an electric motor diagnosis device for such use as in an enclosed switchboard and a control center, for diagnosing the presence or absence of abnormality of an induction motor.

### BACKGROUND ART

Conventionally, an abnormality diagnosis method of a facility is proposed in which a load current of an induction motor is measured, and its frequency analysis is performed; and, by paying attention to sidebands appearing on both sides of an operating frequency, abnormality of the induction motor and an apparatus driven by means of the induction motor is diagnosed, based on the states of disturbances of an waveform lasting for a short period of time in upward and downward directions, and on undulations being an oscillation of an waveform lasting for a long period of time in upward and downward directions, for example Japanese Patent Publication No. 4782218.

Document JP 2016 195524 A, according to its abstract, states a diagnostic equipment having a current detection unit that detects a current on an electric motor and inputs the same to a current input unit. A logic arithmetic unit analyzes the frequency of current wave form when the current is stable and performs a series of averaging processing on a power spectrum analysis result which is obtained by performing averaging processing plural times. By detecting the sideband wave from the power spectrum analysis result after the averaging processing, the presence or absence of abnormality on the electric motor is determined. When any abnormality is determined, an alarm is output from an alarm output unit.

Document JP 2015 227889 A**,** according to its abstract, states that in an abnormality diagnosis method of rotary machine systems that are driven by an electric motor, current signals at the operation time of the electric motor are sampled, and it is determined that an alignment abnormality is generated between a shaft of the rotor of the electric motor connected by a transmission joint in the rotary machine system and the rotary shaft of a load side under the condition that a difference between a level of a spectral peak of the power source frequency of the electric motor and the power source frequency appeared symmetrical at a position of the frequency separated by a rotary frequency of the shaft of the rotor of the electric motor is below the preset value after going through Fourier transform.

Document CN 105510051 A states a new-energy automobile fault diagnosis system based on IOT (Internet of Things) and cloud computing. The new-energy automobile fault diagnosis system is formed by multiple new-energy automobile monitors and a new-energy automobile fault monitoring center, wherein each new-energy automobile monitor comprises a wireless communication module, a microprocessor, a current and voltage sensor, a temperature sensor, a revolution speed sensor, an accelerator pedal sensor, an electric motor monitor, a storage battery monitor, an early warning device and a power supply.

### SUMMARY OF THE INVENTION

### [Problems to be Solved by the Invention]

In a conventional abnormality diagnosis method of a facility, there arises a problem in that, when load torque variations of an induction motor occur, spectrum intensity increases on both sides in vicinity to a power source frequency (operating frequency), and then the spectrum intensity becomes larger than oscillation intensity of sideband frequencies appearing in peak states on both sides of the power source frequency, so that it is difficult to detect the sideband frequencies.

The present invention has been directed at solving those problems described above, and an object of the invention is to provide an electric motor diagnosis device capable of diagnosing the presence or absence of abnormality of an electric motor by means of detecting sideband frequencies appearing in peak states on both sides in vicinity to a power source frequency, even in the electric motor whose load torque varies.

### [Means for Solving the Problems]

An electric motor diagnosis device according to the present invention comprises: an electric current digital conversion device having an electric current input unit for detecting and inputting therein an electric current of an electric motor and a transmission-data conversion unit for converting electric current data of an electric current being detected in the electric current input unit into transmission data; and a data calculation device for inputting transmission data from the electric current digital conversion device by way of a communications line(s), wherein the data calculation device comprises: an FFT analysis unit for analyzing, based on electric current data of an electric current being detected in the electric current input unit and being obtained by way of a communications line when an electric current from the electric current input unit is in a stable state, a power spectrum of the electric current; an averaging calculation unit for smoothing a plurality of charges of power spectrums analyzed by the FFT analysis unit; a sideband frequency extraction unit for extracting a sideband frequency of a power spectrum smoothed by the averaging calculation unit; a sideband frequency determination unit for determining from the number of a sideband frequency or frequencies, and from signal intensity thereof, being extracted by the sideband frequency extraction unit, whether the electric motor is abnormal or not; and a warning output unit for performing a warning output when abnormality is determined by the sideband frequency determination unit, wherein said electric current data of the electric motor obtained by the electric current input unit is supplied by way of an internet network into an electric motor's diagnosis tool on a cloud.

### [Effects of the Invention]

According to the present invention, the diagnosis device comprises: an electric current input unit for detecting and inputting therein an electric current of an electric motor; an FFT analysis unit for analyzing, based on electric current data of an electric current being detected in the electric current input unit and being obtained by way of a communications line when an electric current from the electric current input unit is in a stable state, a power spectrum of the electric current; an averaging calculation unit for smoothing a plurality of charges of power spectrums analyzed by the FFT analysis unit; a sideband frequency extraction unit for extracting a sideband frequency of a power spectrum smoothed by the averaging calculation unit; a sideband frequency determination unit for determining from the number of a sideband frequency or frequencies, and from signal intensity thereof, being extracted by the sideband frequency extraction unit, whether the electric motor is abnormal or not; and a warning output unit for performing a warning output when abnormality is determined by the sideband frequency determination unit, so that, by performing the analysis of a power spectrum by the FFT analysis unit when an electric current is in a stable state, it becomes possible to reliably detect a peak position(s) appearing on both sides of a power source frequency. In addition, by smoothing a plurality of charges of power spectrums by the averaging calculation unit, signal intensity of a peak position(s), for example, due to noise or the like mixing into a power spectrum (s) is lowered, and so, it is made possible to more reliably extract a sideband frequency or frequencies by the sideband frequency extraction unit, and thus, there exists an effect that an electric motor diagnosis device can be obtained which is capable of diagnosing the presence or absence of abnormality of an electric motor by means of detecting sideband frequencies appearing in peak states on both sides in vicinity to a power source frequency, even in the electric motor whose load torque varies.

In addition, because transmission data is transmitted into the data calculation device by way of a communications line(s), the data calculation device can be placed at an arbitrary location, and the warning output unit can also be placed near the user.

Moreover, because an electric current digital conversion device which is arranged in every one of electric motors has only a function of digital conversion, it is made possible to configure the device by an inexpensive CPU whose processing capacity is low, or by an inexpensive ASIC and/or FPGA of small-scale gate capacity.

Furthermore, because transmission data is transmitted into the data calculation device by way of the communications line(s), the data calculation device is capable of accepting inputs from a plurality of electric current digital conversion devices, so that it is possible to diagnose abnormality of the plurality of electric motors by using one data calculation device.

### BRIEF DESCRIPTION OF DRAWINGS

FIG. 1 is a schematic configuration diagram illustrating an installation situation of an electric motor diagnosis device according to Embodiment 1 of the present invention;
FIG. 2 is a block diagram illustrating a configuration of a logic calculation unit of the electric motor diagnosis device according to Embodiment 1 of the present invention;
FIG. 3 is an illustrative diagram for explaining the transformation of frequency axes in the electric motor diagnosis device according to Embodiment 1 of the present invention;
FIG. 4 is a flow chart for explaining the operations of the electric motor diagnosis device according to Embodiment 1 of the present invention;
FIG. 5 is an illustrative diagram for explaining a setting on a threshold value of the electric motor diagnosis device according to Embodiment 1 of the present invention;
FIG. 6 is a schematic configuration diagram illustrating an installation situation of an electric motor diagnosis device according to Embodiment 2 of the present invention;
FIG. 7 is a block diagram illustrating a configuration of a logic calculation unit of the electric motor diagnosis device according to Embodiment 2 of the present invention;
FIG. 8 is a graphical trend representation diagram showing a trend of electric current's spectrum related to mechanical vibrations in the electric motor diagnosis device according to Embodiment 2 of the present invention;
FIG. 9 is a graphical trend representation diagram showing a trend of electric current' s spectrum related to bearing damage in the electric motor diagnosis device according to Embodiment 2 of the present invention;
FIG. 10 is a diagram showing a state in which electric current's spectrums are overlapped on one another and are demonstrated in the electric motor diagnosis device according to Embodiment 2 of the present invention;
FIG. 11 is a flow chart for explaining the operations of the electric motor diagnosis device according to Embodiment 2 of the present invention;
FIG. 12 is a configuration diagram illustrating an electric motor diagnosis device according to Embodiment 3 of the present invention; and
FIG. 13 is a block diagram illustrating a configuration of a logic calculation unit of the electric motor diagnosis device according to Embodiment 3 of the present invention.

### EMBODIMENTS FOR CARRYING OUT THE INVENTION

Hereinafter, the explanation will be made referring to the drawings for the embodiments according to the present invention.

Note that, in each of the figures, the same reference numerals and symbols designate the same items as, or the items corresponding to, those shown in the drawings.

### Embodiment 1.

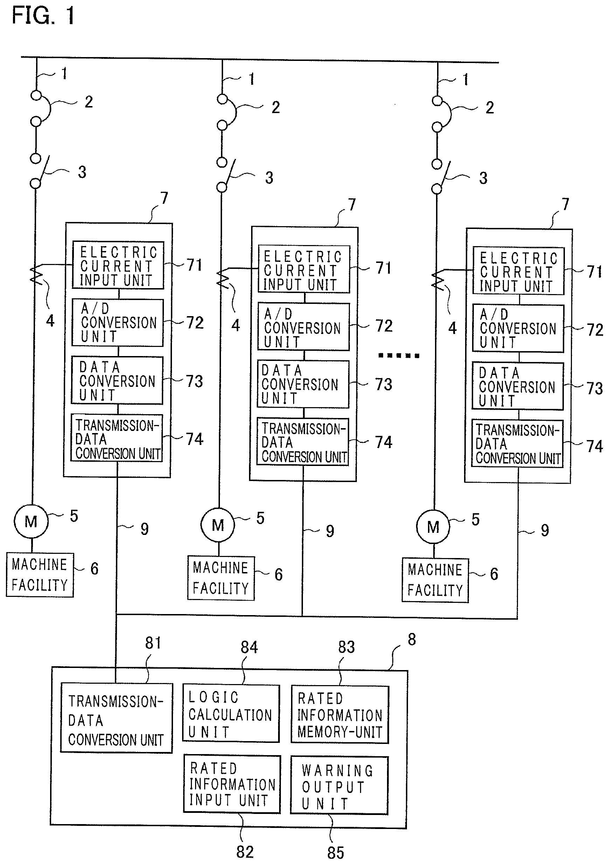

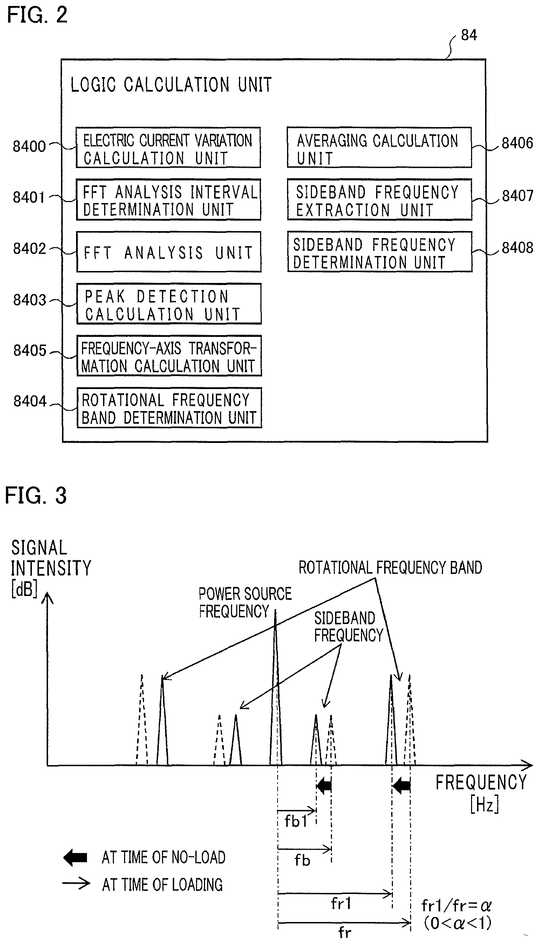

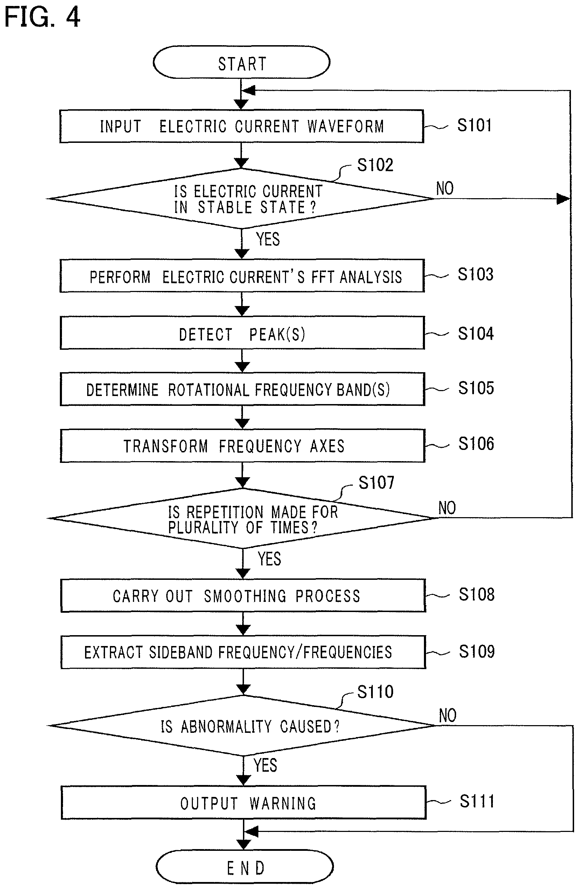

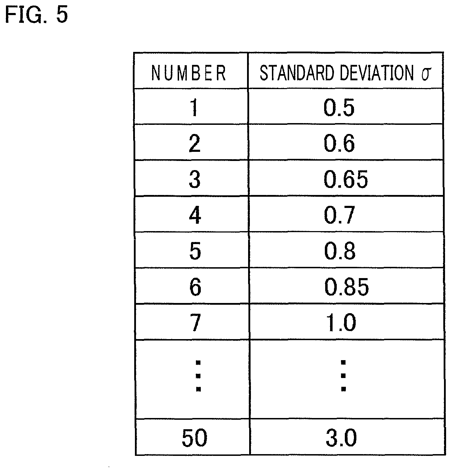

FIG. 1 is a schematic configuration diagram illustrating an installation situation of an electric motor diagnosis device according to Embodiment 1 of the present invention; FIG. 2, a block diagram illustrating a configuration of a logic calculation unit of the electric motor diagnosis device according to Embodiment 1; FIG. 3, an illustrative diagram for explaining the transformation of frequency axes in the electric motor diagnosis device according to Embodiment 1; FIG. 4, a flow chart for explaining the operations of the electric motor diagnosis device according to Embodiment 1; and FIG. 5, an illustrative diagram for explaining a setting on a threshold value of the electric motor diagnosis device according to Embodiment 1.

In FIG. 1, for a main circuit 1 which is led in from an electric power system, provided are a molded-case circuit-breaker 2, an electromagnetic contactor 3, and an electric current detector 4 such as a instrument transformer or the like for detecting a load current of one phase through the three-phase main circuit 1. To the main circuit 1, an electric motor 5 is connected which is a load such as a three-phase induction motor or the like, and a machine facility 6 is operationally driven by means of the electric motor 5. With respect to such facilities, the electric motor diagnosis device according to the embodiment has electric current digital conversion devices 7 and a data calculation device 8, and it is so configured that the electric current digital conversion devices 7 and the data calculation device 8 are connected with one another by way of communications lines 9 by cable or radio. In addition, a plurality of groups of such electric motors 5 and machine facilities 6 is placed with respect to those main circuits 1, and the plurality of electric current digital conversion devices 7 is similarly provided in the manner corresponding to each group of the electric motor 5 and the machine facility 6. Into the data calculation device 8, transmission data from the plurality of electric current digital conversion devices 7 is inputted by way of the communications lines 9.

The electric current digital conversion devices 7 composing the electric motor diagnosis device in part are each constituted of: an electric current input unit 71 for inputting an electric current detected by the electric current detector 4; an A/D conversion unit 72 for converting an electric current, inputted from the electric current input unit 71, from its analog form into a digital one; a data conversion unit 73 for converting digital data obtained by the A/D conversion unit 72 into digital data of a predetermined form; and a transmission-data conversion unit 74 for converting digital data from the data conversion unit 73 into transmission data.

Transmission data generated by the electric current digital conversion devices 7 each is transmitted by way of the communications line 9 into the data calculation device 8 which composes the electric motor diagnosis device in part.

For the data calculation device 8, provided are a transmission-data conversion unit 81 for converting transmission data, inputted by way of the communications lines 9 from the transmission-data conversion units 74 each in the electric current digital conversion devices 7, into data of a predetermined form; a rated information input unit 82 for inputting in advance a power source frequency, and a rated output of the electric motor 5, a rated voltage thereof, a rated electric current thereof, the number of poles, the number of rated revolutions thereof, and the like; and a rated information memory-unit 83 for storing nominal or rated information inputted from the rated information input unit 82. The rated information is information which can be easily acquired by having a look at a manufacturing company's catalog of the electric motor 5, or at its plate attached on the electric motor 5. Note that, when there exists a plurality of such electric motors 5 as diagnosis targets under consideration, rated information of the electric motors 5 as all of the diagnosis targets under consideration is inputted in advance; however, in the following description, the explanation will be made for the single electric motor 5.

In the electric motor diagnosis device, transmission data through from the communications line 9 is treated by processing into a digital value (s) by using the transmission-data conversion unit 81.

For the electric motor diagnosis device, provided are a logic calculation unit 84 for diagnosing the presence or absence of abnormality of the electric motor 5, and a warning output unit 85 for outputting a warning by means of an alert, lighting of an abnormality lamp or the like, when abnormality is discovered by the logic calculation unit 84.

The explanation will be made referring to FIG. 2 for a configuration of the logic calculation unit 84.

The logic calculation unit 84 is constituted of: an electric current variation calculation unit 8400 for acquiring the presence or absence of deviation or variation of an electric current inputted from the electric current input unit 71; an FFT (Fast Fourier Transform) analysis interval determination unit 8401 for extracting, by using a result having been acquired by the electric current variation calculation unit 8400, a section or an interval in which an electric current (s) is stable, and for determining a power spectrum analysis interval; an FFT analysis unit 8402 for performing power spectrum analysis by using an electric current of the interval having been determined by the FFT analysis interval determination unit 8401; a peak detection calculation unit 8403 for detecting a peak position(s) included in a power spectrum having been analyzed by the FFT analysis unit 8402; a rotational frequency band determination unit 8404 for acquiring, from the peak position (s) having been detected by the peak detection calculation unit 8403, a peak position (s) originated as a cause in a rotational frequency (s) ; a frequency-axis transformation calculation unit 8405 for making frequencies in rotational frequency bands of a plurality of charges of power spectrums coincident with each other; an averaging calculation unit 8406 for carrying out an averaging or smoothing process on a plurality of charges of power spectrums whose frequency axes have been transformed by the frequency-axis transformation calculation unit 8405; a sideband frequency extraction unit 8407 for extracting, using a power spectrum having been smoothed by the averaging calculation unit 8406, a peak position(s) whether it exists or not on both sides of a power source frequency (hereinafter, the peak position is referred to as a "sideband frequency") other than that existing in a rotational frequency band(s); and a sideband frequency determination unit 8408 for determining, when a sideband frequency or frequencies are extracted by the sideband frequency extraction unit 8407, whether signal intensity of the sideband frequency or frequencies is a preset value(s) or more.

The electric current variation calculation unit 8400 calculates stochastic variation or variance of electric current values on the basis of an electric current from the electric current input unit 71. As for the calculation of variance, there exist techniques of, for example, a standard deviation, the Mahalanobis' distance and so forth.

The FFT analysis interval determination unit 8401 extracts, from stochastic variation or variance of electric current values having been acquired by the electric current variation calculation unit 8400, only an electric current's interval (s) in which the variance is in a threshold value or less and the electric current values are in a stable state, and then determines a power spectrum analysis interval. In general, when load torque of the electric motor 5 varies, variance is caused in electric current values; and so, when power spectrum analysis is performed on an electric current waveform whose variance is large, signal intensity on both sides in vicinity to a power source frequency results in increasing, so that a peak position (s) of a sideband frequency and the like cease appearing.

That is to say, it is increasingly performed that a peak position (s) of a sideband frequency or frequencies is included within a signal intensity distribution on both sides in vicinity to the power source frequency, so that it is no more possible to detect a peak position(s) of the sideband frequency or frequencies. In order to prevent this occurring, a threshold value of the FFT analysis interval determination unit 8401 is provided therefor.

The FFT analysis unit 8402 calculates electric current's power spectrum intensity by performing frequency analysis using an electric current waveform inputted in an interval having been determined by the FFT analysis interval determination unit 8401. By performing power spectrum analysis using an electric current waveform in which electric current values are in a stable state, there arises no case in which power spectrum intensity increases on both sides in vicinity to a power source frequency, so that, whenever there exists a peak position(s), it can reliably appear.

The peak detection calculation unit 8403 detects, from an analytical result of the electric current's power spectrum intensity, a peak position associated with a power source frequency, peak positions associated with a rotational frequency, peak positions associated with sideband frequencies, and other peak positions. As for detection of peak positions, the detection is made possible by extracting portions from a result calculated by differential calculations of a first-order, a second-order and a third-order where steep gradients reverse at those portions. By performing the differential calculations up to the third-order, it becomes possible to achieve the detection of a peak position of still smaller signal intensity. A peak position associated with a power source frequency can be easily verified because it appears at a place of the power source frequency (in general, 50 Hz or 60 Hz) maintained in the rated information memory-unit 83.

The rotational frequency band determination unit 8404 acquires a rotational frequency from the number of rated revolutions stored in the rated information memory-unit 83, and extracts peak positions existing at places, each being displaced by the quantity of the rotational frequency and having similar signal intensity, in the neighborhood on both sides centering on the power source frequency. In general, a slip is caused in the electric motor 5 in response to the conditions of its load torque, so that displacement is caused in the number of revolutions; and thus, a peak position (s) originated as a cause in a rotational frequency(s) also appears being displaced by the quantity of displacement. The rotational frequency band determination unit 8404 is a unit which extracts a peak position existing in a frequency band taking the displacement into consideration, and determines the peak position as a rotational frequency band.

The frequency-axis transformation calculation unit 8405 is required to accurately perform the smoothing calculation that is carried out by the averaging calculation unit 8406. In general, an appearing place of a sideband frequency which appears due to abnormality of the electric motor 5 has a close relationship to a rotational frequency, and there frequently arises a case in which a frequency band of the sideband frequency is a multiple of the rotational frequency. In addition, a rotational frequency or frequencies appear being displaced in response to the conditions of load torque of the electric motor 5 as in the explanation described above.

For this reason, it is required that a plurality of charges of analytical results of power spectrums being smoothing targets is made coincident with each other on their frequency axes by means of a peak position follow-up scheme. To be specific, as shown in FIG. 3, given that a frequency in a rotational frequency band is at a distant place from a power source frequency by "fr, " and a frequency of a sideband is at a distant place from the power source frequency by "fb," and that a frequency in a rotational frequency band in which the electric motor 5 is in its no-load state is at a distant place from the power source frequency by "fr1," a transformation factor "α" is given by α = fr1/fr, so that, when a place of a sideband frequency at the time of no-load is defined as "fb1," a place of the sideband frequency at the time of loading which is defined as "fb" can be derived from fb = fb1/α.

Note that, the broken-line portions shown in FIG. 3 indicate a signal intensity distribution at a time when there exists a load, and the solid-line portions indicate a signal intensity distribution at the time of no-load.

According to the above, by regarding a rotational frequency band as a reference and by dividing by a transformation factor "α," transformation of frequency axes is performed for all of the peak positions.

It should be noted that, in the description stated above, the explanation is made in a case in which a frequency axis is made coincident with that at the time of no-load; however, for example, a frequency axis may be made coincident with that at the time of a rated load, and so forth. It is simply required that the frequency-axis transformation calculation unit 8405 is configured so that frequency axes of a plurality of charges of analytical results of power spectrums being smoothing targets are made coincident with those at the time of a predetermined load.

The averaging calculation unit 8406 is a unit in which an averaging or smoothing process is carried out on a plurality of charges of analytical results of power spectrums whose frequency axes are made coincident with each other by the frequency-axis transformation calculation unit 8405; and so, by carrying out the smoothing process, base or ground noise is lowered, so that it is made possible to enhance an S/N ratio of the peak positions. To be specific, when the smoothing process is carried out on ten charges of analytical results of power spectrums, a peak position, which only appears on one charge due to noise or the like, results in being reduced to one tenth of the signal intensity. Meanwhile, when there appear a rotational frequency band and a sideband frequency, peak positions each repeatedly appear for ten times, so that frequencies are made coincident with each other even when frequency axes are transformed by means of a peak follow-up scheme; thus, even after the smoothing being made, signal intensity of the peak positions does not change. Note that, in the description stated above, the explanation is made in a case in which ten charges of analytical results of power spectrums are smoothed; however, it is not necessarily limited to the ten charges of them, and so, it suffices to smooth a plurality of charges of them.

The sideband frequency extraction unit 8407 extracts, from analytical results of power spectrums on which the smoothing process is carried out by the averaging calculation unit 8406, peak positions as sideband frequencies which appear centering on the power source frequency at places on both sides each being displaced by the quantity of the same frequency. As for a candidate of a sideband frequency, a peak position having been obtained by the peak detection calculation unit 8403 is selected as the candidate. In a case in which, centering on the power source frequency, a peak position appears only on one side, determination is performed that it is not a sideband frequency, so that it is not extracted.

The sideband frequency determination unit 8408 determines from the number of a sideband frequency or frequencies, and from signal intensity thereof, having been extracted by the sideband frequency extraction unit 8407, whether the electric motor 5 is abnormal or not. When it is determined that the electric motor 5 is abnormal, a warning is outputted from the warning output unit 85.

Next, the explanation will be made referring to FIG. 4 for the operations. FIG. 4 is a flow chart for explaining the operations of the electric motor diagnosis device according to Embodiment 1. The electric motor diagnosis device is started up in predetermined time spacings, and the device executes the following processes. At Step S101, an electric current of the electric motor 5 detected by the electric current detector 4 is inputted using the electric current input unit 71. At Step S102, variance of an electric current's root-mean-square value (hereinafter, referred to as an "electric current value") inputted from the electric current input unit 71 is calculated by the electric current variation calculation unit 8400, and, by using a calculation result therefrom, determination is performed by the FFT analysis interval determination unit 8401 whether an electric current is in a stable state. As a determination result, if variance of electric current values is a threshold value being set in advance or more in an unstable state (NO), the processing is returned to Step S101, and is repeated until the electric current becomes in a stable state. If an electric current is in a stable state (YES), the processing proceeds to Step S103. Note that, in relation to a threshold value, for example, field data of a plurality of motors is preliminarily acquired, and, from an electric current's variation value (a standard deviation) of the data, the selection is made in a range in which variation values are small, so that a value having been selected is defined as the threshold value. As a specific calculation example, variation values are calculated for 50 times, as shown in FIG. 5 for example, and the variation values are rearranged in increasing order of them: by making them coincident with their determination sensitivity, a variation value being the n-th smallest one among those values (for example, when a highly sensitive setting is applied to them, the value "0.8" being a fifth data obtained from a measurement result of experimental data) is determined as a threshold value. It should be noted that, in place of the preliminary field data, a constant learning time-period is provided in the electric motor 5, and similar calculation may be carried out from an electric current's variation value (a standard deviation) having been acquired during the learning time-period.

At Step S103, the FFT analysis unit 8402 performs, by using an electric current waveform in an interval in which electric current values having been inputted are in a stable state, frequency analysis between the frequencies from 0 Hz to 120 Hz, a two-fold frequency of a power source frequency of 60Hz, and hands out an analytical result of power spectrum to the peak detection calculation unit 8403. At Step S104, the peak detection calculation unit 8403 detects all of peak positions included in the analytical result of power spectrum. At Step S105, the rotational frequency band determination unit 8404 extracts a peak position (s) existing in a rotational frequency band(s) among peak positions having been detected, and determines rotational frequency bands. At Step S106, the frequency-axis transformation calculation unit 8405 transforms frequency axes of all of the peak positions so that the rotational frequency bands having been detected take on rotational frequency bands at the time of no-load. At Step S107, by repeating the operations from Step S101 to Step S106 for ten times, ten analytical results of power spectrums whose frequency axes have been transformed are gathered.

At Step S108, the averaging calculation unit 8406 carries out the smoothing process on the ten analytical results of power spectrums having been gathered. At Step S109, the sideband frequency extraction unit 8407 extracts a sideband frequency or frequencies by paying attention to peak positions in an analytical result of the power spectrums on which the smoothing process has been carried out. At Step S110, in a case in which a sideband frequency is not extracted by the sideband frequency extraction unit 8407, or a case in which, although sideband frequencies are extracted, their signal intensity is smaller than a preset value, the sideband frequency determination unit 8408 determines that abnormality is not caused in the electric motor 5 (NO), so that the diagnosis processing is ended. Meanwhile, in a case in which signal intensity of sideband frequencies extracted by the sideband frequency extraction unit 8407 is larger than a preset value (YES), it is determined that abnormality is caused in the electric motor 5, so that a signal is sent to the warning output unit 85; and then, at Step S111, a warning is outputted from the warning output unit 85, and the diagnosis processing is ended. Note that, as for a preset value(s) of the sideband frequency determination unit 8408, signal intensity "A" of a sideband frequency at a normal time is learned, and a standard deviation "σ" is calculated, the preset value (s) is defined in a range in which the data of 99.7 % exists therein, where a peak value of sideband frequency having been detected is in "A + 3σ." Instead of that, a value "A + 3σ × α" may be adopted by multiplication of a safety factor 'α' (for example, 2 or more). In addition, as another method of determining the aforementioned preset value, a preset value can be determined from data or the like of a similar electric motor at the time of its past fault (s) ; the more there are exemplary fault cases, it becomes capable of determining an accurate location of a fault by means of a sideband frequency(s) and an extent of the fault thereby.

As described above, by performing power spectrum analysis on an electric current waveform when its electric current values are stable, peak positions of a sideband frequency and the like reliably appear. In addition, by carrying out the smoothing process, noise or the like is lowered, so that a more accurate fault diagnosis can be achieved.

In addition, because transmission data is transmitted into the data calculation device by way of those communications lines, the data calculation device can be placed at an arbitrary location, and the warning output unit can also be placed near the user.

Moreover, because an electric current digital conversion device which is arranged in every one of electric motors has only a function of digital conversion, it is made possible to configure the device by an inexpensive CPU whose processing capacity is low, or by an inexpensive ASIC and/or FPGA of small-scale gate capacity.

Furthermore, because transmission data is transmitted into the data calculation device by way of the communications lines, the data calculation device is capable of accepting inputs from a plurality of electric current digital conversion devices, so that it is possible to diagnose abnormality of the plurality of electric motors by using one data calculation device.

### Embodiment 2.

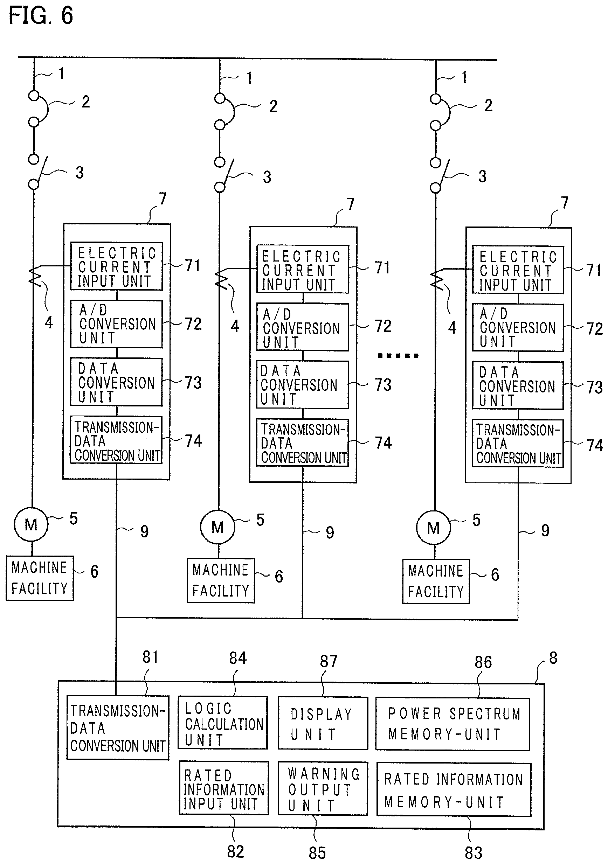

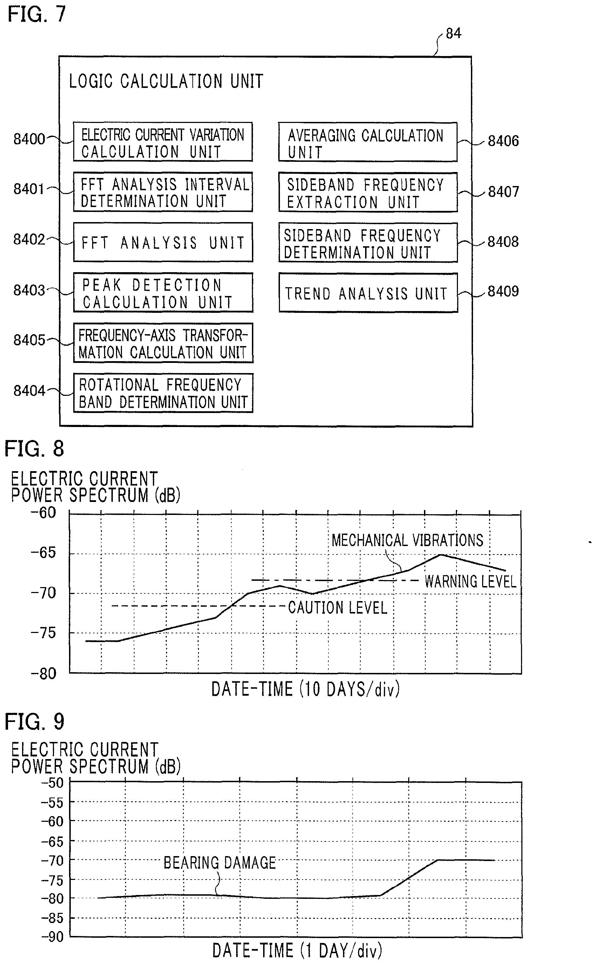

FIG. 6 is a schematic configuration diagram illustrating an installation situation of an electric motor diagnosis device according to Embodiment 2 of the present invention; and FIG. 7, a block diagram illustrating a configuration of a logic calculation unit of the electric motor diagnosis device according to Embodiment 2 of the present invention.

The electric motor diagnosis device according to Embodiment 2 is the same in its basic configuration as the electric motor diagnosis device according to Embodiment 1; however, for the data calculation device 8, a power spectrum memory-unit 86 and a display unit 87 are provided.

In addition, for the logic calculation unit 84, a trend analysis unit 8409 is provided. The power spectrum memory-unit 86 stores, in a time series, analytical results of power spectrums on which a smoothing process has been carried out. The display unit 87 can show a power spectrum(s).

FIG. 8 is a graphical trend representation diagram showing a tendency or trend of electric current's power spectrum related to mechanical vibrations in the electric motor diagnosis device . The graphical representation is made as a diagram in which a rotational frequency of the electric current's power spectrum is represented as a trend graph, which correlates to the magnitude of electric motor's mechanical vibrations, and thus, the graph resides in detecting abnormality of an electric motor (s) before its late-stage degradation, immediately before giving rise to bring its breakdown.

In general, because electric motor's maintenance in factories is carried out by means of the five senses, there frequently arises a case in which determination of abnormality is performed on the basis of an unusual sound of an electric motor (s) . Because of this, it is desirable to make the detection possible even at a level of time causing an unusual sound of the electric motor (s) ; however, by means of a power spectrum (s) of a rotational frequency, the detection of abnormality is made possible even at a level of time causing the unusual sound.

FIG. 9 is a graphical trend representation diagram showing a tendency or trend of electric current's power spectrum related to bearing damage of an electric motor (s) in the electric motor diagnosis device.

It is difficult to detect a power spectrum of bearing damage to an electric motor unless that it is at a late-stage failure or fault of the electric motor, so that electric motor's precise diagnosis is required at once when the spectrum becomes larger.

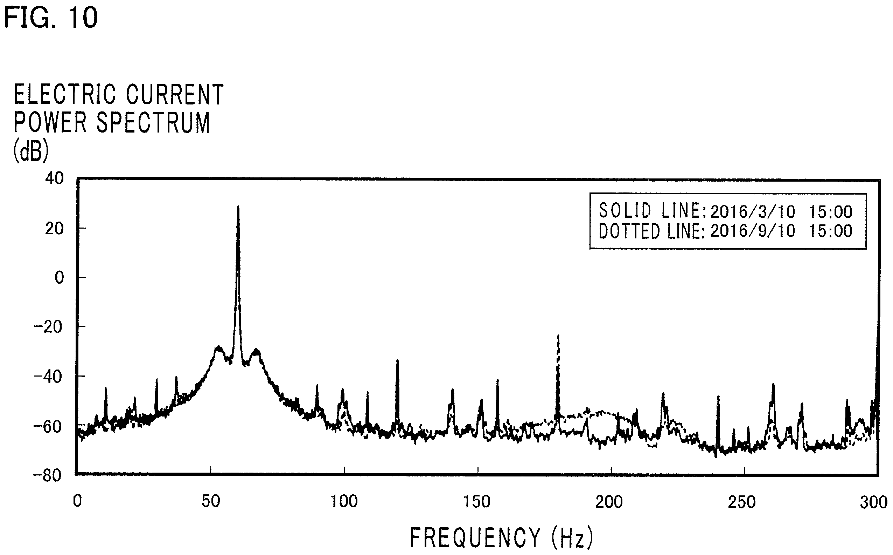

FIG. 10 is a diagram in which electric current's power spectrums at specific dates and times are overlapped on one another. For example, by graphically representing in colors by which a power spectrum diagram at a normal time is overlapped on a power spectrum diagram when degradation has been in progress, different points of the spectrums can be known at first sight.

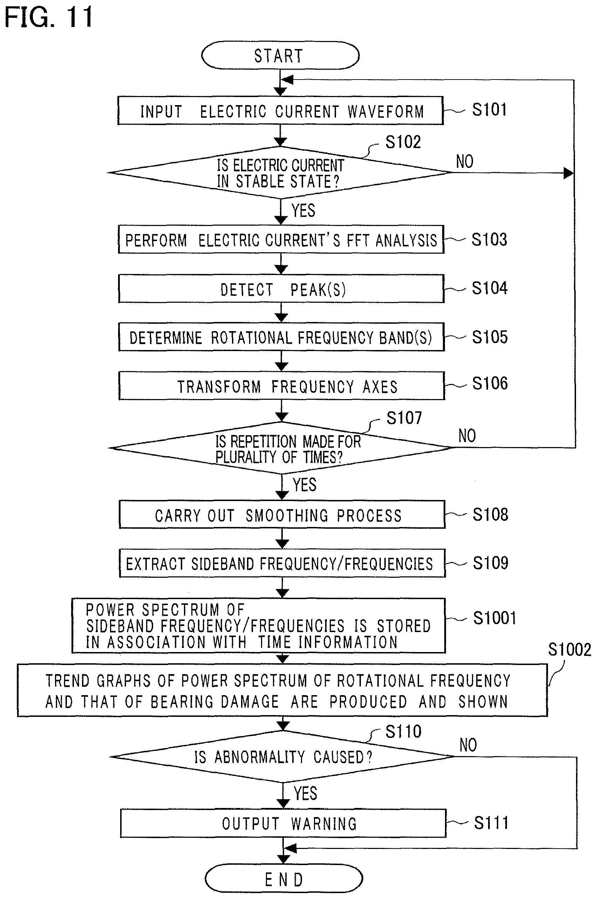

Next, the operations of the electric motor diagnosis device according to Embodiment 2 will be explained. FIG. 11 is a flow chart for showing a flow of the operations of processing by the electric motor diagnosis device according to Embodiment 2. The operations of processing by the electric motor diagnosis device according to Embodiment 2 are the same as those by the electric motor diagnosis device according to Embodiment 1 in their basic parts; however, the processing has Step S1001 and Step S1002. At Step S1001, a power spectrum of sideband frequency or frequencies having been extracted at Step S109 is stored by the power spectrum memory-unit 86 in association with time information. At Step S1002, trend graphs of a power spectrum of a rotational frequency and that of bearing damage are produced by the trend analysis unit 8409, and are shown on the display unit 87.

Next, the operations of the trend analysis unit 8409 will be explained. The trend analysis unit 8409 is a unit in which, by paying attention to a sideband frequency or frequencies of specific frequencies in analytical results of power spectrums stored in the power spectrum memory-unit 86 in a time series, signal intensity of the sideband frequency or frequencies is acquired in a time series and then displayed, as shown in FIG. 8 and FIG. 9. Preset values in FIG. 8 and FIG. 9 are the preset values used by the sideband frequency determination unit 8408. According to the above, by performing trend analysis, abnormality is not yet taken on when, for example, it is assumed that a sideband frequency or frequencies are caused due to the wearing away of a bearing (s) of the electric motor 5, and when signal intensity of the sideband frequency or frequencies is small, whereby the degree of the wearing away of the bearing (s) is small; however, because the wearing away of a bearing(s) gradually increases, the signal intensity of sideband frequency or frequencies tends also to gradually increase in the time series as shown in FIG. 9. Therefore, a timing can be known by performing the trend analysis by which, when the signal intensity of a sideband frequency or frequencies reaches at a preset value, the replacement of a bearing (s) becomes necessary. Note that, other items and components are the same as, or similar to those in Embodiment 1; thus, their explanation is omitted.

### Embodiment 3.

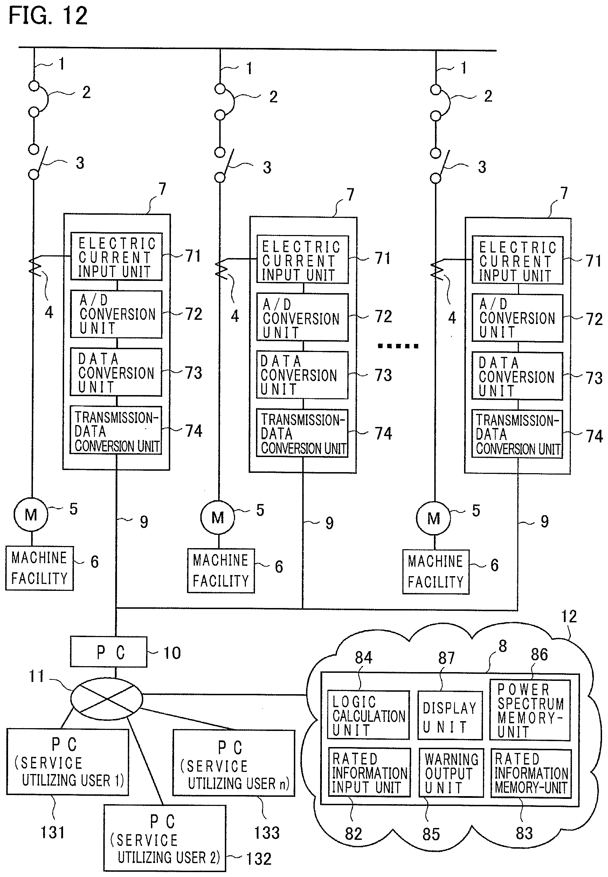

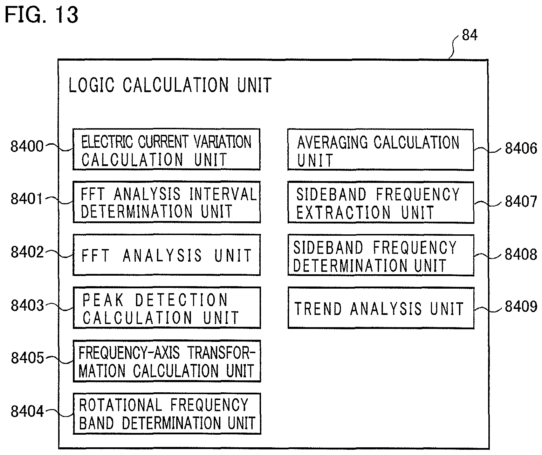

FIG. 12 is a configuration diagram illustrating an electric motor diagnosis device according to Embodiment 3 of the present invention; and FIG. 13, a block diagram illustrating a configuration of a logic calculation unit of the electric motor diagnosis device according to Embodiment 3 of the present invention.

The electric motor diagnosis device according to Embodiment 3 is the same in its basic configuration as the electric motor diagnosis device according to Embodiment 2; however, as illustrated in FIG. 12, electric current data digitized into a form similar to those of Embodiment 1 and Embodiment 2 is inputted from the electric current digital conversion devices 7 into a personal computer (hereinafter, referred to as a "PC") 10 by way of the communications lines 9.

The PC 10 is interconnected to an Internet network 11, whereby software of an electric motor's diagnosis tool is operated at all times on a cloud (cloud computing) 12 which is dedicated as the data calculation device 8, so that electric motor diagnosis functions operate on the cloud. To the Internet network 11, PCs 131, 132 and 133 are interconnected, which are users utilizing the service of electric motor diagnosis. Display data on the display unit 87 is shown on display units of the PCs 131, 132 and 133 each.

As for the electric motor diagnosis functions, they are similar to those in Embodiment 1 and Embodiment 2.

As for advantageous effects to operate on a cloud, a PC's operating system (OS) is not dependent thereon, and an upgrade of software of the diagnosis tool is performed on the cloud, and thus, it becomes possible to offer an upgrade service without altering anything on a user' s PC (s) . As for the electric current data which is digitized into a form, it is possible to offer a service thereof in either case of storing the data on the cloud, or case of storing it on a PC(s).

In addition, it becomes possible for a plurality of users utilizing the service to receive the service offer by making access to the software on the cloud.

### [Explanation of Numerals and Symbols]

Numeral "1" designates a main circuit; "2," molded-case circuit-breaker; "3," electromagnetic contactor; "4," electric current detector; "5," electric motor; "6," machine facility; "7," electric current digital conversion device; "8," data calculation device; "71," electric current input unit; "72," A/D conversion unit; "82," rated information input unit; "83," rated information memory-unit; "84," logic calculation unit; "85," warning output unit; "86," power spectrum memory-unit; "87," display unit; "8400," electric current variation calculation unit; "8401," FFT analysis interval determination unit; "8402," FFT analysis unit; "8403," peak detection calculation unit; "8404," rotational frequency band determination unit; "8405," frequency-axis transformation calculation unit; "8406," averaging calculation unit; "8407," sideband frequency extraction unit; "8408," sideband frequency determination unit; and "8409," trend analysis unit.

## Claims

1. An electric motor diagnosis device, comprising:
an electric current digital conversion device (7) having an electric current input unit (71) for detecting and inputting therein an electric current of an electric motor (5) and a transmission-data conversion unit (74) for converting electric current data of an electric current being detected in the electric current input unit (71) into transmission data; and
a data calculation device (8) for inputting transmission data from the electric current digital conversion device (7) by way of a communications line (9), wherein
the data calculation device (8) comprises:
an FFT analysis unit (8402) for analyzing, based on electric current data from the electric current digital conversion device (7) when an electric current from the electric current input unit (71) is in a stable state, a power spectrum of the electric current;
an averaging calculation unit (8406) for smoothing a plurality of charges of power spectrums analyzed by the FFT analysis unit (8402);
a sideband frequency extraction unit (8407) for extracting a sideband frequency of a power spectrum smoothed by the averaging calculation unit (8406);
a sideband frequency determination unit (8408) for determining from a number of a sideband frequency and from signal intensity thereof, extracted by the sideband frequency extraction unit (8407), whether the electric motor (5) is abnormal or not; and
a warning output unit (85) for performing a warning output when abnormality is determined by the sideband frequency determination unit (8408), wherein said electric current data of the electric motor (5) obtained by the electric current input unit (71) is supplied by way of an internet network (11) into an electric motor's diagnosis tool on a cloud (12).

2. The electric motor diagnosis device as set forth in claim 1, wherein the FFT analysis unit (8402) is so arranged as to analyze a power spectrum of an electric current, on a basis of said electric current data from a plurality of units each identical to the electric current input unit (71), being obtained by way of the communications line (9).

3. The electric motor diagnosis device as set forth in claim 1 or claim 2, further comprising
a peak detection calculation unit (8403) for detecting a peak position in a power spectrum acquired by the FFT analysis unit (8402), wherein
the averaging calculation unit (8406) smooths in a state in which peak positions associated with rotational frequency bands, by transforming a plurality of charges of power spectrum's frequency axes associated therewith, are made coincident with each other.

4. The electric motor diagnosis device as set forth in any one of claims 1 through 3, further comprising:
a power spectrum memory-unit (86) for storing information of a power spectrum smoothed by the averaging calculation unit (8406);
a trend analysis unit (8409) for performing trend analysis on a sideband frequency of a power spectrum in accordance with information of a power spectrum stored in the power spectrum memory-unit (86); and
a display unit (87) for showing trend data obtained by the trend analysis unit (8409).

## Patentansprüche

1. Elektromotor-Diagnoseeinrichtung, mit:
einer Elektrischer-Strom-Digital-Wandlereinrichtung (7), die eine Elektrischer-Strom-Eingabeeinheit (71) zum Detektieren und Eingeben darin eines elektrischen Stroms von einem Elektromotor (5) und eine Übertragungsdatenwandlereinheit (74) zum Wandeln von Elektrischer-Strom-Daten von einem elektrischen Strom, der in der Elektrischer-Strom-Eingabeeinheit (71) detektiert ist, in Übertragungsdaten; und
einer Datenberechnungseinrichtung (8) zum Eingeben von Übertragungsdaten von der Elektrischer-Strom-Digital-Wandlereinrichtung (7) über eine Kommunikationsleitung (9), wobei
die Datenberechnungseinrichtung (8) aufweist:
eine FFT-Analyseeinheit (8402) zum Analysieren, basierend auf Elektrischer-Strom-Daten von der Elektrischer-Strom-Digital-Wandlereinrichtung (7), wenn ein elektrischer Strom von der Elektrischer-Strom-Eingabeeinheit (71) in einem stabilen Zustand ist, eines Leistungsspektrums des elektrischen Stroms;
eine Durchschnittsberechnungseinheit (8406) zum Glätten einer Mehrzahl von Ladungen von Leistungsspektra, die durch die FFT-Analyseeinheit (8402) analysiert sind;
eine Seitenbandfrequenzextraktionseinheit (8407) zum Extrahieren einer Seitenbandfrequenz eines Leistungsspektrums, das durch die Durchschnittsberechnungseinheit (8406) geglättet ist;
eine Seitenbandfrequenzbestimmungseinheit (8408) zum Bestimmen, aus einer Anzahl von Seitenbandfrequenzen und von Signalintensitäten davon, die durch die Seitenbandfrequenzextraktionseinheit (8407) extrahiert sind, ob der Elektromotor (5) abnormal oder nicht ist; und
eine Alarmausgabeeinheit (85) zum Durchführen einer Alarmausgabe, wenn eine Abnormalität durch die Seitenbandfrequenzbestimmungseinheit (8408) bestimmt ist, wobei die Elektrischer-Strom-Daten des Elektromotors (5), die durch die Elektrischer-Strom-Eingabeeinheit (71) erlangt sind, mittels eines Internetnetzwerks (11) in ein Diagnosewerkzeug bzw. Diagnoseprogramm eines Elektromotors in einer Cloud (12) zugeführt werden.

2. Elektromotor-Diagnoseeinrichtung nach Anspruch 1, wobei die FFT-Analyseeinheit (8402) derart angeordnet ist, dass sie ein Leistungsspektrum eines elektrischen Stroms analysiert auf einer Basis der Elektrischer-Strom-Daten von einer Mehrzahl von Einheiten, die jeweils identisch zu der Elektrischer-Strom-Eingabeeinheit (71) sind, die mittels der Kommunikationsleitung (9) erlangt werden.

3. Elektromotor-Diagnoseeinrichtung nach Anspruch 1 oder Anspruch 2, des Weiteren mit
einer Spitzendetektionsberechnungseinheit (8403) zum Detektieren einer Spitzenposition in einem Leistungsspektrum, das durch die FFT-Analyseeinheit (8402) erlangt ist, wobei
die Durchschnittsberechnungseinheit (8406) in einem Zustand glättet, indem Spitzenpositionen, die mit Rotationsfrequenzbändern verknüpft sind, indem eine Mehrzahl von Frequenzachsen der Leistungsspektra, die damit verknüpft sind, transformiert werden, koinzident miteinander gemacht werden

4. Elektromotor-Diagnoseeinrichtung nach einem der Ansprüche 1 bis 3, des Weiteren mit:
einer Leistungsspektrumspeichereinheit (86) zum Speichern von Information eines Leistungsspektrums, das durch die Durchschnittsberechnungseinheit (8406) geglättet ist;
einer Trendanalyseeinheit (8409) zum Durchführen einer Trendanalyse an einer Seitenbandfrequenz eines Leistungsspektrums gemäß Informationen eines Leistungsspektrums, das in der Leistungsspektrumspeichereinheit (86) gespeichert ist; und
einer Anzeigeeinheit (87) zum Darstellen von Trenddaten, die durch die Trendanalyseeinheit (8409) erlangt sind.

## Revendications

1. Dispositif de diagnostic de moteur électrique comprenant :
un dispositif de conversion numérique de courant électrique (7) comportant une unité d'entrée de courant électrique (71) destinée à détecter et à recevoir en entrée un courant électrique d'un moteur électrique (5), ainsi qu'une unité de conversion de données de transmission (74) destinée à convertir en données de transmission les données du courant électrique détecté dans l'unité d'entrée de courant électrique (71), et
un dispositif de calcul de données (8) destiné à recevoir entrer les données de transmission émises par le dispositif de conversion numérique de courant électrique (7) au moyen d'une ligne de communication (9), où
le dispositif de calcul de données (8) comprend :
une unité d'analyse par transformation FFT (8402) destinée à analyser le spectre de puissance du courant électrique, sur la base des données de courant électrique émises par le dispositif de conversion numérique de courant électrique (7) lorsque le courant électrique provenant de l'unité d'entrée de courant électrique (71) se trouve dans un état stable,
une unité de calcul de moyenne (8406) destinée à lisser une pluralité de charges de spectres de puissance analysées par l'unité d'analyse par transformation FFT (8402),
une unité d'extraction de fréquence de bande latérale (8407) destinée à extraire la fréquence de bande latérale d'un spectre de puissance lissé par l'unité de calcul de moyenne (8406),
une unité de détermination de fréquence de bande latérale (8408) destinée à déterminer à partir du numéro d'une fréquence de bande latérale et à partir de l'intensité de son signal, extraits par l'unité d'extraction de fréquence de bande latérale (8407), si le moteur électrique (5) est dans un état anormal ou non, et
une unité d'émission d'alarme (85) destinée à effectuer une émission d'alarme lorsqu'une anomalie est déterminée par l'unité de détermination de fréquence de bande latérale (8408), lesdites données de courant électrique du moteur électrique (5), obtenues par l'unité d'entrée de courant électrique (71), étant délivrées au moyen d'un réseau Internet (11) dans un outil de diagnostic de moteur électrique sur une informatique en nuage (12).

2. Dispositif de diagnostic de moteur électrique selon la revendication 1, dans lequel l'unité d'analyse par transformation FFT (8402) est disposée de façon à analyser le spectre de puissance d'un courant électrique sur la base desdites données de courant électrique provenant d'une pluralité d'unités, chacune identique à l'unité d'entrée de courant électrique (71), obtenues au moyen de la ligne de communication (9).

3. Dispositif de diagnostic de moteur électrique selon la revendication 1 ou la revendication 2, comprenant en outre :
une unité de calcul de détection de crête (8403) destinée à détecter la position de la crête dans un spectre de puissance acquis par l'unité d'analyse par transformation FFT (8402), où
l'unité de calcul de moyenne (8406) effectue le lissage dans un état dans lequel sont rendues coïncidant les unes avec les autres les positions des crêtes associées à des bandes de fréquences rotationnelles, en transformant une pluralité de charges d'axes de fréquences de spectres de puissance qui leur sont associés.

4. Dispositif de diagnostic de moteur électrique selon l'une quelconque des revendications 1 à 3, comprenant en outre :
une unité de mémoire de spectre de puissance (86) destinée à stocker des informations d'un spectre de puissance lissé par l'unité de calcul de moyenne (8406),
une unité d'analyse de tendance (8409) destinée à effectuer une analyse de tendance sur une fréquence de bande latérale d'un spectre de puissance en fonction des informations d'un spectre de puissance qui sont stockées dans l'unité de mémoire de spectre de puissance (86), et
une unité d'affichage (87) destinée à représenter les données de tendance obtenues par l'unité d'analyse de tendance (8409).
